# FASCICULE DE BREVET EUROPEEN

(11) **EP 3 826 068 B1**
(45) Date de publication et mention de la délivrance du brevet: **31.08.2022**
(21) Numéro de dépôt: 20207370.6
(22) Date de dépôt: 13.11.2020
(51) Int. Cl.: H01L 27/15, H01L 33/38, H01L 33/44

(54) **PROCÉDÉ DE FORMATION D'UNE ÉLECTRODE COMMUNE D'UNE PLURALITÉ DE DISPOSITIFS OPTOÉLECTRONIQUES**
VERFAHREN ZUM ERZEUGEN EINER GEMEINSAMEN ELEKTRODE FÜR EINE VIELZAHL VON OPTOELEKTRONISCHEN VORRICHTUNGEN
METHOD FOR FORMING A COMMON ELECTRODE FOR A PLURALITY OF OPTOELECTRONIC DEVICES

(30) Priorité: 21.11.2019 FR 1913028
(43) Date de publication de la demande: 26.05.2021
(73) Titulaire: Commissariat à l'énergie atomique et aux énergies alternatives, 75015 Paris (FR)
(72) Inventeur: VOLPERT, Marion, 38054 GRENOBLE CEDEX 09 (FR)
(74) Mandataire: Brevalex

(56) Documents cités:
- EP-A1- 3 401 958
- WO-A1-2019/092357
- US-A1- 2015 295 009

## Description

### DOMAINE TECHNIQUE

L'invention se rapporte aux domaines de la microélectronique, et de l'optoélectronique. En particulier, l'invention concerne un procédé de formation de contacts électriques au niveau des flancs de dispositifs, et plus particulièrement de diodes électroluminescentes, reposant sur une face principale d'un substrat support.

La présente invention est notamment mise en œuvre pour la fabrication simplifiée, et avec un contrôle accru, d'une électrode sur les flancs de LEDs présentant en particulier des rapports d'aspect importants.

### ÉTAT DE LA TECHNIQUE ANTÉRIEURE

Un dispositif d'affichage émissif connu de l'état de la technique comprend généralement un ensemble de diodes électroluminescentes (LEDs), notamment à base de nitrure de gallium.

Ces LEDs comprennent, de leur face avant vers leur face arrière, une couche de semi-conducteur dopé N, un ensemble de couches émissives ainsi qu'une couche de semi-conducteur dopé P, et reposent, par leur face arrière, sur un substrat support pourvu d'un circuit de contrôle destiné à adresser de manière individuelle chacune desdites LEDs au niveau de leur couche de semi-conducteur dopé P.

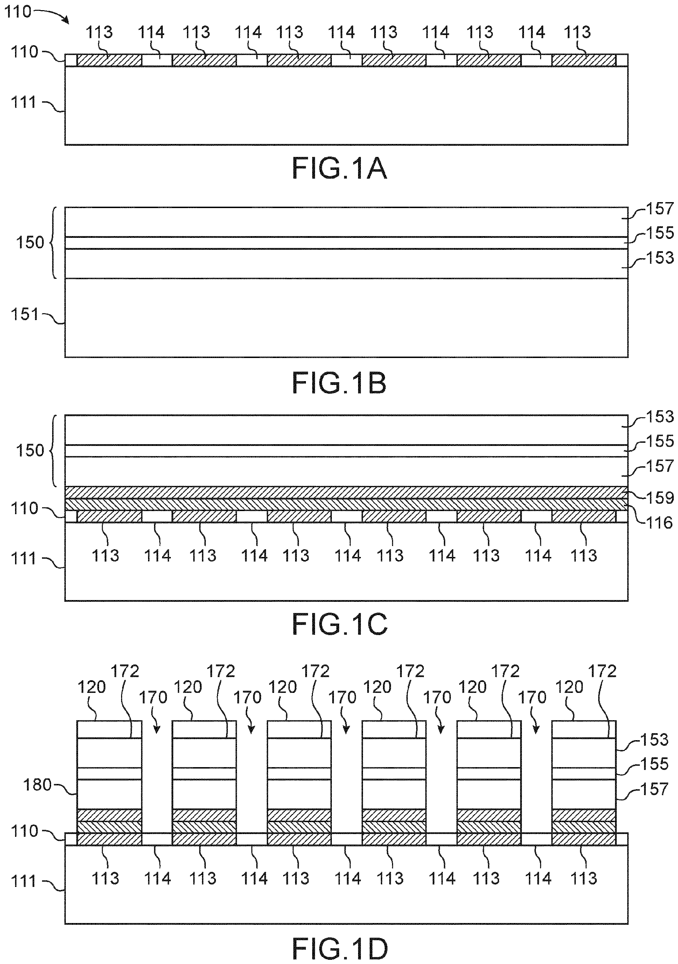

Le dispositif d'affichage émissif comprend en outre une électrode commune contactant électriquement la couche de semi-conducteur dopé N de chacune des LEDs. Ce contact électrique est généralement pris au niveau du flanc de la couche de semi-conducteur. Ainsi, un procédé de formation d'un dispositif d'affichage émissif connu de l'état de la technique est illustré aux figures 1A à 1G.

Le procédé comprend notamment une étape, illustrée à la figure 1A, qui consiste à fournir un substrat support 111 sur une face principale duquel un circuit intégré 110 de contrôle est formé. Le circuit intégré comprend notamment des plots métalliques de connexion 113, isolés les uns des autres par des zones diélectriques 114, et destinés à connecter les LEDs par leur face arrière.

La figure 1B est une représentation schématique d'un empilement de couches 150 formées sur une face principale d'un substrat support 151. L'empilement de couches comprend notamment, à partir de la face principale, une couche de semi-conducteur dopée N 153, un ensemble de couches émissives 155 ainsi qu'une couche de semi-conducteur dopé P 157. Chacune de ces couches peut comprendre du nitrure de gallium. L'empilement de couches 150, selon le procédé connu de l'état de la technique, est ensuite reporté sur la face principale du substrat support 111 (Figure 1C). Ce report peut comprendre une étape de collage de l'empilement 150 sur le circuit intégré 110 suivie d'un retrait du substrat support 151.

Une ou deux couches intermédiaires métalliques 116 et 159 peuvent par ailleurs être formées, respectivement, sur le circuit intégré 110 et sur l'empilement 150 avant l'étape de collage.

L'étape de report est alors suivie d'une étape au cours de laquelle des tranchées 170 sont formées dans l'empilement 150 depuis la face exposée à l'environnement extérieur dudit empilement, et qui s'étendent sur toute son épaisseur afin de délimiter une pluralité de LEDs 172 (figure 1D).

La formation de tranchées implique généralement les étapes successives suivantes :
- une étape de formation d'une couche de masque dur, par exemple une couche de matériau diélectrique, en recouvrement de la face exposée de l'empilement 150,
- une étape de photolithographie destinée à délimiter des motifs 120 au niveau de la couche de masque dur à l'aide d'une couche de résine photo lithographique,
- une étape de gravure de la couche de masque dur de manière à former les motifs 120 d'un masque dur,
- une étape de retrait de la résine photo lithographique mise en œuvre au cours de l'étape de photolithographie,
- une étape de gravure de l'empilement 150 à travers le masque dur de manière à délimiter les LEDs.

L'étape de gravure peut être poursuivie de manière à retirer également les portions des couches 116 et 159 du fond des tranchées 170.

Ainsi, à l'issue de cette étape, le substrat support 111 comprend une pluralité de LEDs séparées les unes des autres par les tranchées 170.

En particulier, les LEDs reposent par leur face arrière sur la face principale du substrat support 111, tandis que la face avant de chacune d'entre elle, opposée à la face arrière et reliée à cette dernière par un flanc, est recouverte d'un motif 120 de masque dur. Les tranchées 170 sont ainsi délimitées par un fond, au niveau de la face principale du substrat support, et par les flancs des LEDs.

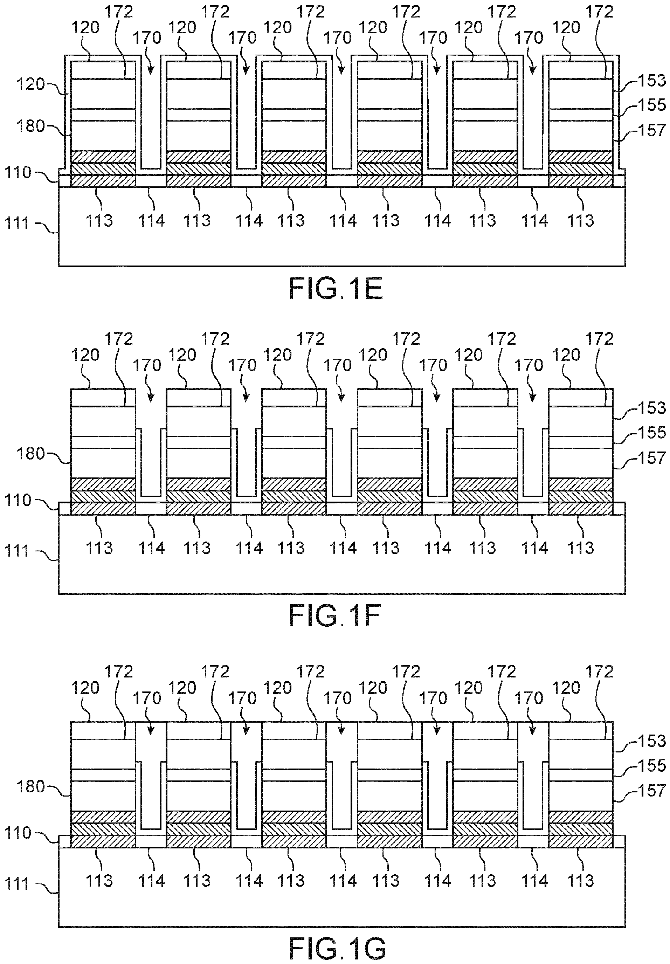

La formation des LEDs est alors suivie d'une étape de passivation de ces dernières (figure 1E). La passivation comprend notamment la formation d'un film de passivation 190 en recouvrement des motifs 120 de masque dur, des flancs 180 des LEDs 172 et du fond des tranchées 170.

Une étape de retrait partiel de la couche de passivation est ensuite exécutée. Cette étape comprend notamment le retrait d'une portion de la couche de passivation en recouvrement des motifs 120 et d'une première section des flancs qui s'étend, à partir de la face avant des LEDs, sur une profondeur inférieure à l'épaisseur de la couche de semi-conducteur dopé N (figure 1F).

En d'autres termes, à l'issue de cette étape, la couche de passivation 190 est conservée sur une deuxième section qui s'étend du fond des tranchées et sur une hauteur qui correspond au moins à l'épaisseur combinée des couches intermédiaires métalliques 116 et 159, de la couche de semi-conducteur dopé P 157 et de l'ensemble des couches émissives 155.

Le retrait met notamment en œuvre une étape de photographie qui comprend le remplissage de la deuxième section des tranchées par une résine photo lithographique, suivie d'une étape de gravure de la couche de passivation au niveau des motifs 120 et de la première section.

Enfin, l'électrode commune est formée par remplissage des tranchées 170 par une espèce métallique.

La formation de l'électrode commune implique notamment la croissance d'une couche de métal, par exemple par électrodéposition en recouvrement des motifs 120 et remplissant les tranchées.

Une étape de polissage mécanochimique, s'arrêtant sur les motifs 120 de masque dur, est ensuite exécutée de manière à ne conserver le métal que dans les tranchées.

Ce procédé n'est cependant pas satisfaisant.

En effet, l'épaisseur des motifs 120 de masque dur n'est pas parfaitement contrôlée au cours, et est en particulier inhomogène d'un motif à l'autre à l'issue de l'étape de formation des tranchées.

Il résulte de cette inhomogénéité une variabilité importante des premières sections d'une tranchée à l'autre, et par voie de conséquence, une difficulté à contrôler précisément l'étendue de la zone de contact entre l'électrode commune et la couche de semi-conducteur dopée N de chacune des LEDs.

Un procédé de formation d'un dispositif d'affichage émissif est aussi divulgué dans chacun des documents EP3401958 A1, US2015295009 A1 et WO2019092357 A1.

Un but de la présente invention est donc de proposer un procédé de formation d'une électrode commune plus simple à mettre en œuvre.

Un autre but de la présente invention est également de proposer un procédé de formation d'une électrode commune plus fiable et présentant moins de variabilité que les procédés connus de l'état de la technique.

### EXPOSÉ DE L'INVENTION

Les buts de la présente invention sont, au moins en partie, atteints par un procédé de formation d'une électrode commune à une pluralité de dispositifs optoélectroniques comprenant chacun une face avant et une face arrière reliées par un flanc, le procédé comprenant les étapes suivantes :
a) fournir un substrat support sur une face duquel, dite face principale, reposent, par leur face arrière, la pluralité de dispositifs optoélectroniques séparées par des tranchées, lesdites tranchées étant délimitées par les flancs desdits dispositifs optoélectronique et un fond au niveau de la face principale ;
b) former une couche diélectrique en recouvrement des faces avants ainsi que des flancs et du fond des tranchées, la couche diélectrique présentant une épaisseur E1 et une épaisseur E2, inférieure à l'épaisseur E1, au niveau, respectivement, des faces avants et des flancs ;
c) graver par voie humide une épaisseur E3 de la couche diélectrique, inférieur à l'épaisseur E1, et de manière à découvrir les flancs au niveau d'une première section des tranchées et conserver au moins en partie la couche diélectrique sur les faces avant ;
d) former une couche de métal, en recouvrement des tranchées et recouvrant les faces avants, la couche de métal remplissant avantageusement les tranchées
e) exécuter un polissage mécanochimique de la couche de métal, ledit polissage s'arrêtant sur la partie de la couche diélectrique conservée à l'issue de l'étape c), le métal restant dans les tranchées formant l'électrode commune; chaque tranchée comprend, à partir du fond et contigües l'une de l'autre, une deuxième section et la première section qui s'étendant, respectivement, selon une deuxième et une première hauteur, la première section débouchant au niveau d'un plan formée par les faces avant des dispositifs optoélectroniques,
l'étape b) est précédée d'une étape b0) de formation, selon une technique de dépôt conforme, d'une couche de passivation en recouvrement des faces avants ainsi que des flancs et du fond des tranchées, l'étape c) permettant également le retrait de la couche passivation au niveau de la première section.

Selon un mode de mise en œuvre, l'épaisseur E1 est au moins 2 fois supérieure à l'épaisseur E2.

Selon un mode de mise en œuvre, l'étape b0) est exécutée par déposition en couches atomiques.

Selon un mode de mise en œuvre, la couche de passivation comprend au moins des matériaux choisis parmi : SiO₂, Al₂O₃.

Selon un mode de mise en œuvre, la couche de passivation présente une épaisseur comprise entre 5nm et 30 nm.

Selon un mode de mise en œuvre, la couche diélectrique est formée par une technique de dépôt chimique en phase vapeur activée par plasma.

Selon un mode de mise en œuvre, la couche diélectrique comprend au moins un des matériaux choisis parmi : SiO₂, Si₃N₄.

Le nitrure de silicium, Si3N4, considéré dans la présente invention n'est pas forcément stoechiométrique.

Selon un mode de mise en œuvre, l'étape a) comprend le report d'un empilement de couches, formées sur un substrat germe, sur la face principale du substrat support.

Selon un mode de mise en œuvre, le report de l'empilement de couches est suivi de la formation des tranchées qui s'étendent sur toute l'épaisseur de l'empilement.

Selon un mode de mise en œuvre, la formation des tranchées met en œuvre un masque dur qui est retiré avant l'exécution de l'étape b).

Selon un mode de mise en œuvre, les dispositifs optoélectroniques sont des diodes électroluminescentes qui comprennent de leur face avant vers leur face arrière, une première couche de semi-conducteur dopé N, un ensemble de couches émissives ainsi qu'une deuxième couche de semi-conducteur dopé P, la première hauteur étant inférieure ou égale à l'épaisseur de la couche de semi-conducteur dopée N.

Selon un mode de mise en œuvre, le substrat support comprend sur sa face principale un circuit intégré destiné à adresser individuellement chacun des dispositifs électroniques.

### BRÈVE DESCRIPTION DES DESSINS

D'autres caractéristiques et avantages apparaîtront dans la description qui va suivre d'un procédé formation de contacts électriques d'une pluralité de dispositifs optoélectroniques selon l'invention, donnés à titre d'exemples non limitatifs, en référence aux dessins annexés dans lesquels :
Les figures 1A, 1B, 1C, 1D, 1E, 1F, 1G sont des représentations schématiques des différentes étapes mises en œuvre pour la fabrication d'un dispositif d'affichage émissif selon un procédé connu de l'état de la technique, les vues relatives à ces figures sont notamment représentées selon un plan de coupe perpendiculaire à la face principale du substrat support ;

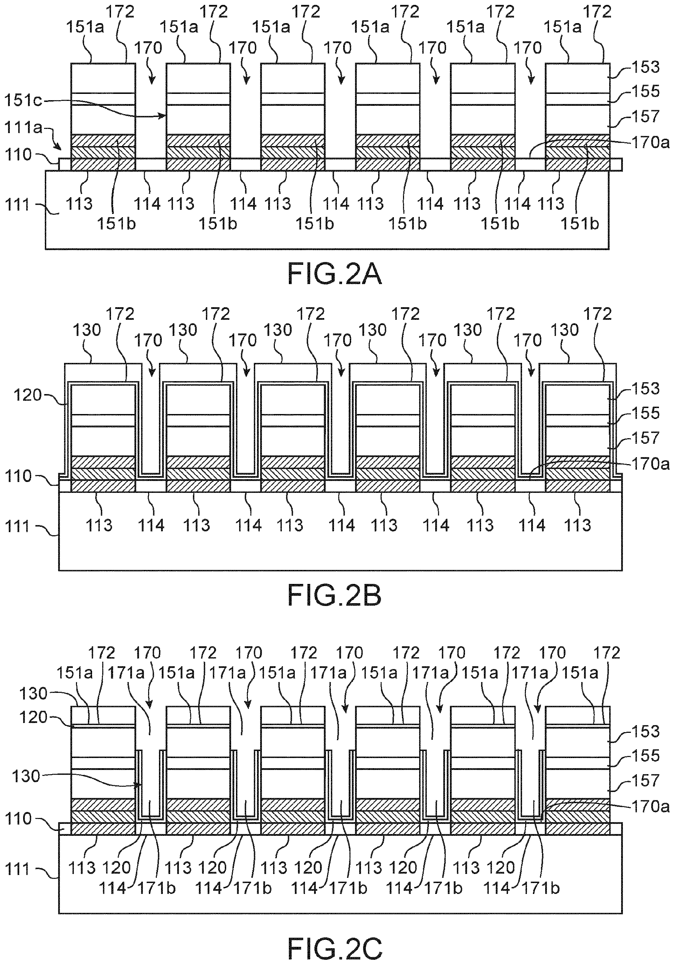

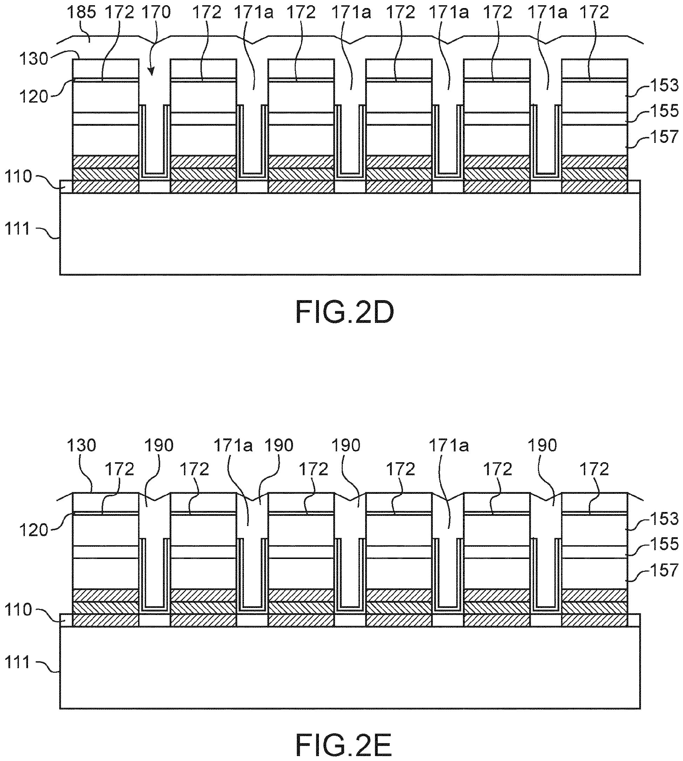

Les figures 2A, 2B, 2C, 2D, 2E sont des représentations schématiques des différentes étapes mises en œuvre pour la fabrication d'un dispositif d'affichage émissif selon la présente invention, les vues relatives à ces figures sont notamment représentées selon un plan de coupe perpendiculaire à la face principale du substrat support ;
Les figures, 3A, 3B, 3C, 3D, 3E, 3F sont des représentations schématiques des différentes étapes susceptibles d'être mises en œuvre pour l'exécution de l'étape a) du procédé selon la présente invention, les vues relatives à ces figures sont notamment représentées selon un plan de coupe perpendiculaire à la face principale du substrat support.

### EXPOSÉ DÉTAILLÉ DE MODES DE RÉALISATION PARTICULIERS

Les mêmes éléments ont été désignés par de mêmes références aux différentes figures et, de plus, les diverses figures ne sont pas tracées à l'échelle. Par souci de clarté, seuls les éléments qui sont utiles à la compréhension des modes de réalisation décrits ont été représentés et sont détaillés.

En particulier, la réalisation d'un circuit intégré de contrôle, connue en soi de l'homme du métier, n'est pas détaillée.

La présente invention concerne un procédé de fabrication d'une électrode commune à des dispositifs optoélectroniques reposant par leur face arrière sur une face principale d'un substrat support.

La suite de la description se limitera à des dispositifs optoélectroniques formés par des diodes électroluminescentes (ci-après « LEDs »). Toutefois, l'homme du métier pourra généraliser l'invention à tout autre type de dispositif, par exemple des photodiodes.

On peut voir aux figures 2A à 2E des représentations schématiques des différentes étapes d'un procédé de fabrication d'une électrode commune à une pluralité de diodes électroluminescentes 172 comprenant chacune une face avant 151a et une face arrière 151b reliées par un flanc 151c.

Le procédé comprend notamment une étape a) qui consiste à fournir un substrat support 111 sur une face duquel, dite face principale 111a, reposent, par leur face arrière 151b, la pluralité de diodes électroluminescentes 172 séparées par des tranchées 170 (figure 2A). Les tranchées 170 sont notamment délimitées par les flancs 151c des diodes électroluminescentes 172 et un fond 170a au niveau de la face principale 111a.

Le substrat support 111 peut comprendre, sur sa face principale 111a, un circuit intégré destiné à adresser individuellement chacune des diodes électroluminescentes 172.

En particulier, le circuit intégré peut comprendre des plots métalliques de connexion 113, isolés les uns des autres par des zones diélectriques 114.

Les plots métalliques de connexion 113 sont notamment destinés à être connectés à chacune des faces arrière 151b des diodes électroluminescentes 172 et ainsi pouvoir commander ces dernières.

Le circuit intégré peut également comprendre, associée à chaque diode électroluminescente 172, une cellule élémentaire pourvue d'un ou plusieurs transistors permettant de contrôler le courant circulant dans ladite diode.

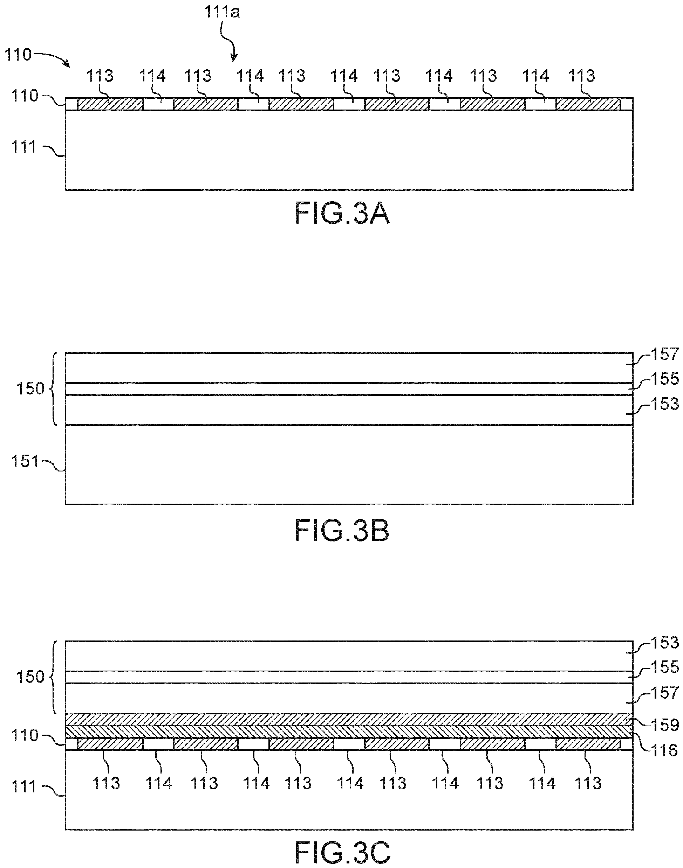

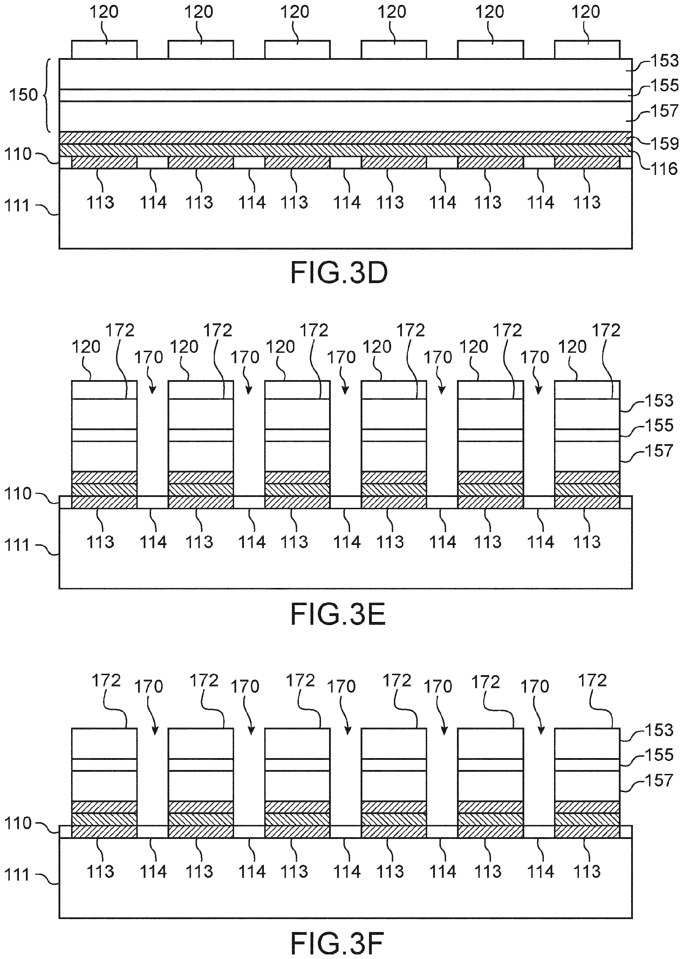

L'exécution de l'étape a) illustrée aux figures 3A à 3F peut notamment comprendre les étapes suivantes :
a0) fournir le substrat support 111 pourvu sur sa face principale 111a du circuit intégré (figure 3A, seuls les plots métalliques 113 et les zones diélectriques 114 sont représentés),
a1) former un empilement de couches 150 sur une première face d'un substrat germe 151, par exemple par épitaxie (figure 3B),
a2) reporter l'empilement de couches 150 sur la face principale 111a (figure 3C), a3) former des tranchées 170 (figures 3D et 3E).

L'étape a3) de formation des tranchées 170 est notamment exécutée par formation d'un masque dur (figure 3D) puis gravure (figure 3E) à travers ce masque de manière à délimiter les diodes électroluminescentes 172.

A cet égard, le masque dur comprend des plots 120, faits par exemple d'un matériau diélectrique, et délimitant l'empreinte des diodes électroluminescentes 172 destinées à être formées. Les plots 120 peuvent notamment présenter une épaisseur comprise entre 500 nm et 1,5 µm, par exemple 1 µm.

Enfin, l'étape a3) est suivie d'un retrait des plots 120 formant le masque dur (figure 3F). Cette dernière étape permettant avantageusement de réduire le rapport d'aspect des structures reposant sur la face principale 111a du substrat support 111.

L'empilement formée à l'étape a1) peut comprendre, à partir de la première face du substrat germe 151, une première couche de semi-conducteur dopé N 153, un ensemble de couches émissives 155 ainsi qu'une deuxième couche de semi-conducteur dopé P 157. En d'autres termes, les diodes électroluminescentes comprennent, de leur face avant 151a vers leur face arrière 151b, la première couche de semi-conducteur dopé N 153, l'ensemble de couches émissives 155 ainsi que la deuxième couche de semi-conducteur dopé P 157. Selon une autre variante, l'ordre des couches de l'empilement peut être inversé.

L'étape a2) peut comprendre le collage du substrat germe (sur lequel est formé l'empilement) sur la face principale 111a du substrat support 111, suivie d'une étape de retrait du substrat germe et d'un amincissement de la couche 153.

La première couche de semi-conducteur dopé N 153 peut comprendre du GaN dopé N, et être d'une épaisseur comprise entre0,5 µm et 0,2 µm

La deuxième couche de semi-conducteur dopé P 157 peut comprendre du GaN dopé P, et être d'une épaisseur comprise entre 0,1 µm et 0,5 µm.

Plus particulièrement, l'épaisseur totale de l'empilement 150 peut être comprise entre 700 nm et 3µm.

Chacune des couches émissives de l'ensemble 155 peut comprendre un puit quantique, par exemple à base de GaN, InN, InGaN, AIGaN, AIN, AlInGaN, GaP, AIGaP, AlInGaP, ou d'une combinaison d'un ou plusieurs de ces matériaux.

A titre de variante, une couche émissive de l'ensemble 155 peut être une couche de nitrure de gallium intrinsèque, c'est-à-dire non intentionnellement dopée, par exemple de concentration en donneurs résiduels comprise entre 10¹⁵ et 10¹⁸ atomes/cm³, par exemple de l'ordre de 10¹⁷ atomes/cm³.

L'étape a2) de report peut être précédée de la formation d'une ou deux couches métalliques 116 et 159 formée, respectivement, en recouvrement de la face principale 111a et de la surface libre de l'empilement 150.

Les deux couches métalliques 116 et 159 sont notamment mises en contact l'une de l'autre lors de l'étape de report a2) (figure 3C).

La couche métallique 116 peut comprendre du titane et de l'aluminium.

La couche métallique 159 peut comprendre un empilement d'une couche d'aluminium et d'une couche de titane, ladite couche de titane étant destinée à être au contact de la couche métallique 116.

La couche métallique 116 peut présenter une épaisseur comprise entre 300 nm et 1 µm, par exemple 600 nm.

La couche métallique 159 peut présenter une épaisseur comprise entre 50 nm et 300 nm, par exemple 100 nm.

Dès lors que les deux couches métalliques 116 et 159 sont considérées, il est entendu que les tranchées 170 formées à l'étape a3) s'étendent également sur toute l'épaisseur combinée de ces deux couches (figure 3E).

Le procédé selon la présente invention comprend également une étape b) exécutée après l'étape a).

Notamment l'étape b) comprend la formation d'une couche diélectrique 130 en recouvrement des faces avant 151a ainsi que des flancs 151c et du fond 170a des tranchées 170 (figure 2B).

La couche diélectrique 130 présente notamment une épaisseur E1 et une épaisseur E2, inférieure à l'épaisseur E1, au niveau, respectivement, des faces avants 151a et des flancs 170a.

Par exemple, l'épaisseur E1 est au moins 2 fois supérieure à l'épaisseur E2.

Toujours à titre d'exemple, l'épaisseur E1 peut être comprise entre 100 nm et 500 nm, par exemple être égale à 200 nm.

La couche diélectrique 130 peut être formée par une technique de dépôt chimique en phase vapeur activée par plasma. Cette technique, dans la mesure où elle permet le dépôt de couche non conforme (i.e. : présentant un taux de dépôt supérieur sur la face avant 151a au regard de flancs 151c), est particulièrement avantageuse pour la réalisation de la présente invention. L'invention n'est toutefois pas limitée à cette seule technique de dépôt et l'homme du métier pourra employer toute autre technique susceptible de déposer des couches de manière non conforme.

La couche diélectrique 130 peut comprendre au moins un des matériaux choisis parmi : SiO₂, Si₃N₄.

Selon la présente invention, l'étape b) est précédée d'une étape b0) de formation, selon une technique de dépôt conforme, d'une couche de passivation 120 en recouvrement des faces avant 151a ainsi que des flancs 151c et du fond 170a des tranchées 170.

Par « technique de dépôt conforme », on entend une technique présentant un taux de dépôt sensiblement égal, avantageusement égal, sur les flancs et sur les faces avant. Par « sensiblement égal », on entend un écart relatif inférieur à 10 %, avantageusement inférieur à 5 %.

La couche de passivation 120 peut présenter une épaisseur comprise entre 5 nm et 30 nm, et comprendre au moins des matériaux choisis parmi : SiO₂, Al₂O₃.

La couche de passivation 120 peut être formée par déposition en couches atomiques.

L'étape b) est suivie d'une étape c) qui consiste à graver par voie humide une épaisseur E3 de la couche diélectrique 130, inférieure à l'épaisseur E1, et de manière à découvrir les flancs au niveau d'une première section des tranchées 171a qui s'étend sur une première hauteur à partir de la face avant 151a des diodes électroluminescentes 172 (figure 2C).

L'étape c) est par ailleurs exécutée de manière à conserver au moins en partie la couche diélectrique 130 sur les faces avant 151a.

L'étape c) est également être exécutée de manière à conserver la couche diélectrique 130 au niveau d'une deuxième section 171b de la tranchée 170 contigüe à la première section 171a et qui s'étend à partir de la première section jusque dans le fond 170a de la tranchée 170.

La section de couche diélectrique conservée à l'issue de l'étape b) jouera avantageusement le rôle de couche d'arrêt d'une étape de polissage mécanochimique décrite dans la suite de l'énoncé.

Si la couche de passivation 120 est considérée, cette dernière est également gravée au niveau de la première section 171a.

L'étape c) met avantageusement en œuvre le remplissage de la deuxième section 171b de la tranchée 170 par de la résine photo lithographique, avant la gravure par voie humide. Avantageusement, la première hauteur est inférieure ou égale à l'épaisseur de la couche de semi-conducteur dopée N.

L'étape c) est suivie de la formation de l'électrode commune 190. En particulier, ce procédé comprend une étape d) de formation d'une couche de métal 185 (figure 2D), par exemple par électrodéposition ou par CVD, en recouvrement des faces avant 151a et des tranchées 170, ainsi qu'une étape e) de polissage mécanochimique destinée à ne conserver le métal que dans les tranchées 170.

Par « en recouvrement des tranchées », on entend en recouvrement du flanc et du fond. Selon la présente invention, le recouvrement d'une tranchée n'exclue pas son remplissage.

Toujours selon la présente invention, dans la mesure où l'étape d) ne conduirait pas à un remplissage de la tranchée, une étape de remplissage, par une espèce métallique, destinée à combler le vide dans ladite tranchée pourrait être exécuté.

De manière particulièrement avantageuse, l'étape d) peut être mise en œuvre selon un procédé Damascène.

A cet égard, la partie de la couche diélectrique 130 conservée sur les faces avant 151a à l'issue de l'étape c) sert de couche d'arrêt au polissage.

Le métal restant dans les tranchées 170 à l'issue de l'étape e) forme l'électrode commune contactant électriquement les couche de semi-conducteur dopé N des chacune des diodes électroluminescentes au niveau des flancs desdites diodes.

La présence de la couche diélectrique 130, et éventuellement de la couche de passivation, au niveau de la deuxième section 170b permet d'isoler électriquement l'électrode commune de la deuxième couche de semi-conducteur dopé P 157 et de l'ensemble de couches émissives 155.

L'invention est avantageusement mise en œuvre lorsque les diodes électroluminescentes présentent un rapport d'aspect important et notamment supérieur à 2. En effet, le retrait du masque dur selon la présente invention permet un recouvrement plus aisé des topologies par la couche diélectrique 130 et de la couche de passivation dès lors qu'elle est considérée.

Par ailleurs, la face avant (et par voie de conséquence la première couche de semi-conducteur dopé N 153) des diodes électroluminescentes est protégée par le couche diélectrique 130 lors de l'étape de polissage mécanochimique.

## Revendications

1. Procédé de formation d'une électrode commune (190) à une pluralité de dispositifs optoélectroniques comprenant chacun une face avant (151a) et une face arrière (151b) reliées par un flanc (151c), le procédé comprenant les étapes suivantes :
a) fournir un substrat support (111) sur une face duquel, dite face principale (111a), reposent, par leur face arrière (151b), la pluralité de dispositifs optoélectroniques séparées par des tranchées (170), lesdites tranchées (170) étant délimitées par les flancs (151c) desdits dispositifs optoélectroniques et un fond au niveau de la face principale (111a) ;
b) former une couche diélectrique (130) en recouvrement des faces avants ainsi que des flancs (151c) et du fond des tranchées (170), la couche diélectrique (130) présentant une épaisseur E1 et une épaisseur E2, inférieure à l'épaisseur E1, au niveau, respectivement, des faces avants et des flancs (151c) ;
c) graver par voie humide une épaisseur E3 de la couche diélectrique (130), inférieure à l'épaisseur E1, et de manière à découvrir les flancs (151c) au niveau d'une première section (171a) des tranchées (170) et conserver au moins en partie la couche diélectrique (130) sur les faces avant ;
d) former une couche de métal (185), en recouvrement des tranchées (170) et recouvrant les faces avants, la couche de métal remplissant avantageusement les tranchées (170) ;
e) exécuter un polissage mécanochimique de la couche de métal (185), ledit polissage s'arrêtant sur la partie de la couche diélectrique (130) conservée en recouvrement des faces avant à l'issue de l'étape c), le métal restant dans les tranchées (170) formant l'électrode commune (190) ;
chaque tranchée comprend, à partir du fond et contigüe à la première section, une deuxième section (171b), la première section (171a) et la deuxième section s'étendant, respectivement, selon une première et une deuxième hauteur, la première section (171a) débouchant au niveau d'un plan formé par les faces avant des dispositifs optoélectroniques,
l'étape b) est précédée d'une étape b0) de formation, selon une technique de dépôt conforme, d'une couche de passivation (120) en recouvrement des faces avant ainsi que des flancs (151c) et du fond des tranchées (170), l'étape c) permettant également le retrait de la couche passivation au niveau de la première section (171a).

2. Procédé selon la revendication 1, dans lequel l'épaisseur E1 est au moins 2 fois supérieure à l'épaisseur E2.

3. Procédé selon la revendication 1 ou 2, dans lequel l'étape b0) est exécutée par déposition en couches atomiques.

4. Procédé selon l'une des revendications 1 à 3, dans lequel la couche de passivation (120) comprend au moins des matériaux choisis parmi : SiO₂, Al₂O₃.

5. Procédé selon l'une des revendications 1 à 4, dans lequel la couche de passivation (120) présente une épaisseur comprise entre 5nm et 30 nm.

6. Procédé selon l'une de revendications 1 à 5, dans lequel la couche diélectrique (130) est formée par une technique de dépôt chimique en phase vapeur activée par plasma.

7. Procédé selon l'une des revendications 1 à 6, dans lequel la couche diélectrique (130) comprend au moins un des matériaux choisis parmi : SiO₂, Si₃N₄.

8. Procédé selon l'une des revendications 1 à 7, dans lequel l'étape a) comprend le report d'un empilement de couches, formées sur un substrat germe, sur la face principale (111a) du substrat support (111).

9. Procédé selon la revendication 8, dans lequel le report de l'empilement de couches est suivi de la formation des tranchées (170) qui s'étendent sur toute l'épaisseur de l'empilement.

10. Procédé selon la revendication 9, dans lequel la formation des tranchées (170) met en œuvre un masque dur qui est retiré avant l'exécution de l'étape b).

11. Procédé selon l'une des revendications 1 à 10, dans lequel les dispositifs optoélectroniques sont des diodes électroluminescentes (172) qui comprennent de leur face avant (151a) vers leur face arrière (151b), une première couche de semi-conducteur dopé N (153), un ensemble de couches émissives (155) ainsi qu'une deuxième couche de semi-conducteur dopé P (157), la première hauteur étant inférieure ou égale à l'épaisseur de la couche de semi-conducteur dopée N.

12. Procédé selon la revendication 11, dans lequel le substrat support (111) comprend sur sa face principale (111a) un circuit intégré destiné à adresser individuellement chacun des dispositifs électroniques.

## Patentansprüche

1. Verfahren zur Bildung einer gemeinsamen Elektrode (190) für eine Vielzahl von optoelektronischen Vorrichtungen, die jeweils eine Vorderfläche (151a) und eine Hinterfläche (151b) umfassen, die durch eine Flanke (151c) verbunden sind, wobei das Verfahren die folgenden Schritte umfasst:
a) Bereitstellen eines Trägersubstrats (111) auf dessen einer als Hauptfläche (111a) bezeichneten Fläche, über ihre Hinterfläche (151b) die Vielzahl von optoelektronischen Vorrichtungen, die durch Schneisen (170) abgetrennt sind, aufliegen, wobei die Schneisen (170) durch die Flanken (151c) der optoelektronischen Vorrichtungen und einen Boden im Bereich der Hauptfläche (111a) begrenzt sind;
b) Bilden einer dielektrischen Schicht (130) zur Bedeckung der Vorderflächen sowie der Flanken (151c) und des Bodens der Schneisen (170), wobei die dielektrische Schicht (130) eine Dicke E1 aufweist und eine Dicke E2, die kleiner ist als die Dicke E1, jeweils im Bereich der Vorderflächen an den Flanken (151c);
c) Ätzen im Nassverfahren einer Dicke E3 der dielektrischen Schicht (130), die kleiner ist als die Dicke E1, auf eine Weise, um die Flanken (151c) im Bereich eines ersten Abschnitts (171a) der Schneisen (170) aufzudecken und um die dielektrische Schicht (130) mindestens teilweise an den Vorderflächen zu bewahren;
d) Bilden einer Metallschicht (185) zur Bedeckung der Schneisen (170) und die Vorderflächen bedeckend, wobei die Metallschicht vorteilhafterweise die Schneisen (170) auffüllt;
e) Durchführen eines chemisch-mechanisch Polierens der Metallschicht (185), wobei das Polieren am Teil der bewahrten dielektrischen Schicht (130) zur Bedeckung der Vorderflächen am Ende des Schrittes c) stoppt, wobei das in den Schneisen (170) verbleibende Metall die gemeinsame Elektrode (190) bildet;
jede Schneise umfasst, vom Boden aus und angrenzend an den ersten Abschnitt, einen zweiten Abschnitt (171b), wobei sich der erste Abschnitt (171a) und der zweite Abschnitt jeweils in eine erste und eine zweite Höhe erstrecken, wobei der erste Abschnitt (171a) im Bereich einer Ebene einmündet, die von den Vorderflächen der optoelektronischen Vorrichtungen gebildet wird,
dem Schritt b) geht ein Schritt b0) der Bildung einer Passivierungsschicht (120) voraus, mit einer geeigneten Abscheidungstechnik, zur Bedeckung der Vorderflächen sowie der Flanken (151c) und des Bodens der Schneisen (170), wobei der Schritt c) auch die Entfernung der Passivierungsschicht im Bereich des ersten Abschnitts (171a) ermöglicht.

2. Verfahren nach Anspruch 1, wobei die Dicke E1 mindestens 2-mal größer ist als die Dicke E2.

3. Verfahren nach Anspruch 1 oder 2, wobei der Schritt b0) durch Atomlagenabscheidung durchgeführt wird.

4. Verfahren nach einem der Ansprüche 1 bis 3, wobei die Passivierungsschicht (120) mindestens Materialien umfasst, die ausgewählt werden aus: SiO₂, Al₂O₃.

5. Verfahren nach einem der Ansprüche 1 bis 4, wobei die Passivierungsschicht (120) eine Dicke zwischen 5 nm und 30 nm aufweist.

6. Verfahren nach einem der Ansprüche 1 bis 5, wobei die dielektrische Schicht (130) durch eine plasmaaktivierte chemische Gasphasenabscheidungstechnik gebildet wird.

7. Verfahren nach einem der Ansprüche 1 bis 6, wobei die dielektrische Schicht (130) mindestens eines der Materialien umfasst, das ausgewählt wird aus: SiO₂, Si₃N₄.

8. Verfahren nach einem der Ansprüche 1 bis 7, wobei der Schritt a) die Übertragung eines Schichtstapels, der auf einem Keimsubstrat gebildet wurde, auf die Hauptfläche (111a) des Trägersubstrats (111) umfasst.

9. Verfahren nach Anspruch 8, wobei auf die Übertragung des Schichtstapels die Bildung der Schneisen (170) folgt, die sich über die gesamte Dicke des Stapels erstrecken.

10. Verfahren nach Anspruch 9, wobei bei der Bildung der Schneisen (170) eine Hartmaske erzeugt wird, die vor der Durchführung von Schritt b) entfernt wird.

11. Verfahren nach einem der Ansprüche 1 bis 10, wobei die optoelektronischen Vorrichtungen Leuchtdioden (172) sind, die von ihrer Vorderfläche (151a) zu ihrer Hinterfläche (151b) eine erste n-dotierte Halbleiterschicht (153), eine Einheit von emittierenden Schichten (155) sowie eine zweite p-dotierte Halbleiterschicht (157) umfassen, wobei die erste Höhe kleiner oder gleich der Dicke der n-dotierten Halbleiterschicht ist.

12. Verfahren nach Anspruch 11, wobei das Trägersubstrat (111) auf seiner Hauptfläche (111a) eine integrierte Schaltung umfasst, die zum individuellen Adressieren jeder der elektronischen Vorrichtungen bestimmt ist.

## Claims

1. A method for forming a common electrode (190) with a plurality of optoelectronic devices each comprising a front face (151a) and a rear face (151b) connected by a flank (151c), the method comprising the steps of:
a) providing a support substrate (111) on a face of which, named main face (111a), rest, by a rear face (151b) thereof, the plurality of optoelectronic devices separated by trenches (170), said trenches (170) being delimited by the flanks (151c) of said optoelectronic devices and a bottom at the main face (111a);
b) forming a dielectric layer (130) by covering the front faces, the flanks (151c), and the bottom of the trenches (170), the dielectric layer (130) having a thickness E1 and a thickness E2, which is less than the thickness E1, at, respectively, the front faces and the flanks (151c);
c) wet etching a thickness E3 of the dielectric layer (130), the thickness E3 being less than the thickness E1, so as to uncover the flanks (151c) at a first section (171a) of the trenches (170) and keep at least partially the dielectric layer (130) on the front faces;
d) forming a metal layer (185), by covering the trenches (170) and the front faces; the metal layer filling advantageously the trenches (170);
e) performing a chemical-mechanical polishing of the metal layer (185), said polishing stopping on a portion of the dielectric layer (130) kept by the covering the front faces at the end of step c), the metal remaining in the trenches (170) forming the common electrode (190),
each trench comprises, from the bottom and adjacent to the first section, a second section (171b), the first section (171a) and the second section extending, respectively, according to a first height and a second height, the first section (171a) leading to a plane formed by the front faces of the optoelectronic devices,
step b) is preceded by a step b0) of forming, by a conformal deposition technique, a passivation layer (120) by covering the front faces, the flanks (151c), and the bottom of the trenches (170), the step c) also allowing for removal of the passivation layer at the first section (171a).

2. Method according to claim 1, wherein the thickness E1 is at least 2 times greater than the thickness E2.

3. Method according to claim 1 or 2, wherein the step b0) is performed by atomic layer deposition.

4. Method according to one of claims 1 to 3, wherein the passivation layer (120) comprises at least materials chosen from: SiO₂, Al₂O₃.

5. Method according to one of claims 1 to 4, wherein the passivation layer (120) has a thickness between 5 nm and 30 nm.

6. Method according to one of claims 1 to 5, wherein the dielectric layer (130) is formed by a plasma-activated chemical vapor deposition technique.

7. Method according to one of claims 1 to 6, wherein the dielectric layer (130) comprises at least one of the materials chosen from: SiO₂, Si₃N₄.

8. Method according to one of claims 1 to 7, wherein the step a) comprises a transfer of a stack of layers, formed on a seed substrate, on the main face (111a) of the support substrate (111).

9. Method according to claim 8, wherein the transfer of the stack of layers is followed by formation of trenches (170) that extend over an entire thickness of the stack of layers.

10. Method according to claim 9, wherein the formation of trenches (170) implements a hard mask that is removed before performing the step b).

11. Method according to one of claims 1 to 10, wherein the optoelectronic devices are light emitting diodes (172) that comprise from the front face (151a) thereof to the rear face (151b) thereof, a first N-doped semiconductor layer (153), an assembly of emitting layers (155), and a second P-doped semiconductor layer (157), the first height being less than or equal to a thickness of the N-doped semiconductor layer.

12. Method according to claim 11, wherein the support substrate (111) comprises, on the main face (111a) thereof, an integrated circuit configured to individually address each of the electronic devices.
